(19)

Europäisches
Patentamt

European
Patent Office

Office européen
des brevets

(11) **EP 2 056 340 A1**

(12) **EUROPEAN PATENT APPLICATION**
published in accordance with Art. 153(4) EPC

(43) Date of publication:
**06.05.2009 Bulletin 2009/19**

(51) Int Cl.:
*H01L 21/302* *(2006.01)*    *H01L 21/205* *(2006.01)*
*H01L 33/00* *(2006.01)*

(21) Application number: **07792921.4**

(22) Date of filing: **23.08.2007**

(86) International application number:
**PCT/JP2007/066343**

(87) International publication number:
**WO 2008/023756 (28.02.2008 Gazette 2008/09)**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(30) Priority: **25.08.2006 JP 2006229399**

(71) Applicant: **Sumitomo Electric Industries, Ltd.
Osaka-shi, Osaka 541-0041 (JP)**

(72) Inventors:
• **KINOSHITA, Hiroyuki
Osaka 569-0094 (JP)**
• **SUDA, Jun
Kyoto-shi, Kyoto 615-8510 (JP)**
• **KIMOTO, Tsunenobu
Kyoto-shi, Kyoto 615-8510 (JP)**

(74) Representative: **Grünecker, Kinkeldey,
Stockmair & Schwanhäusser
Anwaltssozietät
Leopoldstraße 4
80802 München (DE)**

(54) **METHOD FOR PRODUCING SILICON CARBIDE SUBSTRATE AND SILICON CARBIDE SUBSTRATE**

(57)    The present invention provides a method for producing a silicon carbide substrate for forming a semiconductor layer by inclining the surface orientation of a major surface (1) of a substrate by 0.03 to 1° from the (0001) plane and performing hydrogen gas etching at 1250°C to 1700°C. Also disclosed is an SiC substrate, which has only a few spiral pits and is excellent in surface flatness.

FIG.1

**Description**

TECHNICAL FIELD

The present invention relates to a silicon carbide (SiC) substrate employed for producing a semiconductor device and a method for producing the same.

BACKGROUND ART

A nitride semiconductor applied to a light-emitting device and a transistor is mainly produced by performing heteroepitaxial growth on a sapphire substrate or an SiC substrate. In particular, the SiC substrate is excellent in lattice matching with the nitride semiconductor, and hence a high-quality nitride semiconductor crystal can be easily stacked thereon. Further, the SiC substrate is so excellent in heat conductivity that the same has excellent advantages such that a high-output device can be produced. SiC crystals are classified into several types in response to the crystal structures. Two types including 4H-SiC in which pairs of silicon and carbon are stacked in a (0001) direction in four cycles and 6H-SiC in which the same are stacked in six cycles are mainly used for the nitride semiconductor.

In a nitride semiconductor device, on the other hand, excellence in quality of a crystal and flatness of the surface remarkably influence the performance of the device, and the quality of the nitride crystal on an SiC substrate and flatness of the surface particularly depend on the state of the surface of the SiC substrate. In order to grow a high-quality flat nitride semiconductor crystal on the SiC substrate, therefore, mirror finishing must be performed on the SiC substrate for preventing flawing and roughening, while the SiC substrate is so extremely hard and chemically stable that there are such problems that efficiency in polishing is inferior, productivity is inferior, and the cost increases.

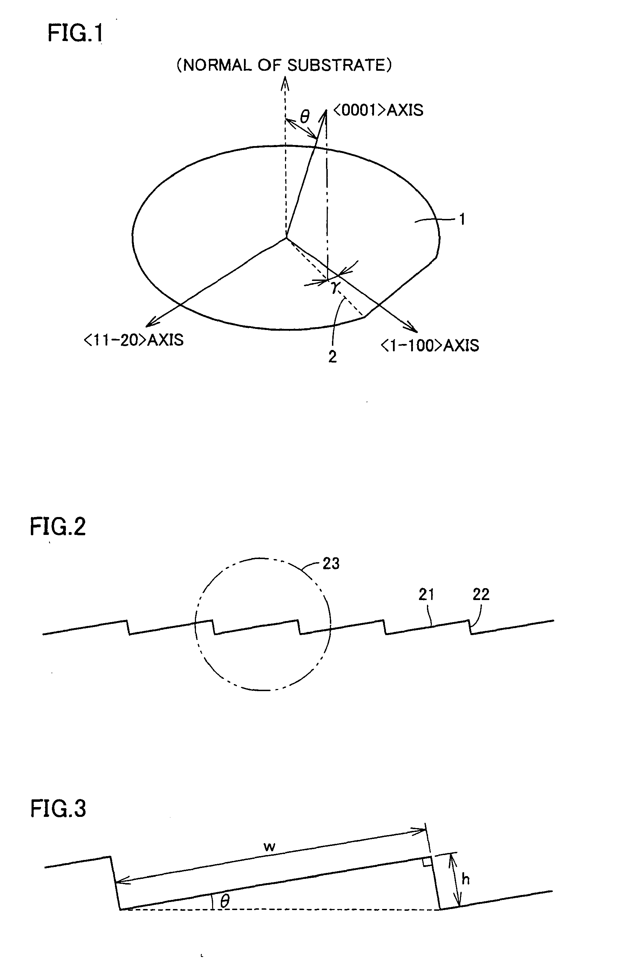

Therefore, there is proposed a method of etching the surface with hydrogen gas (including mixed gas of hydrogen gas and another gas) in order to finish the surface of the SiC substrate (refer to Japanese Patent Laying-Open No. 2001-77030 (Patent Document 1)). It is presented that a high-quality surface having no strain by processes can be obtained on an etched surface by performing etching with hydrogen gas on a substrate finished into a mirror surface. On the surface of an SiC single-crystalline substrate, the atomic arrangement state is exposed if the atomic arrangement of the crystal is not broken, to provide a step-terrace structure composed of flat terraces 21 and steps 22 (steps), as shown in Figs. 2 and 3. Portions of places which correspond to landings are terraces 21, and the terraces provide crystal planes of the surface orientation of the substrate. When a (0001) plane is etched, for example, the terraces are defined by (0001) planes. The width $w$ of the terraces so depends on the inclination θ of the substrate that the width $w$ of the terraces reduces and the number of the steps increases when the inclination θ increases.

Patent Document 1: Japanese Patent Laying-Open No. 2001-77030

DISCLOSURE OF THE INVENTION

PROBLEMS TO BE SOLVED BY THE INVENTION

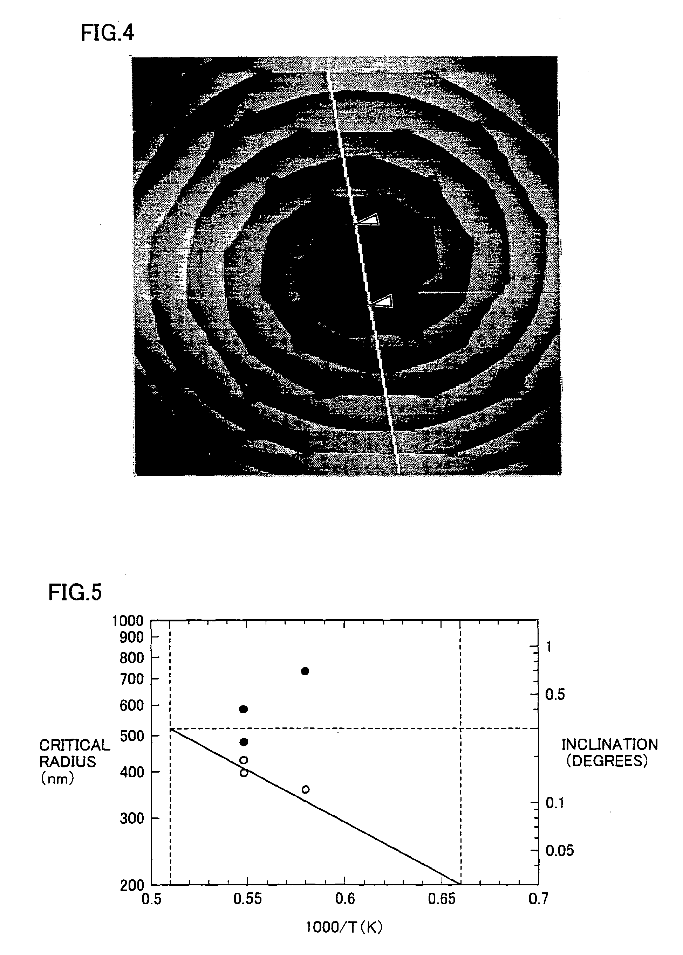

When surface finishing is performed by hydrogen gas etching, however, spiral pits are disadvantageously formed as a bad influence. In other words, the spiral pits which are bowllike pit defects are easily formed on screw dislocations included in an SiC wafer crystal in gas etching. Fig. 4 is a diagram of spiral pits as viewed from above. In the example shown in Fig. 4, two steps grow from a screw dislocation of an SiC substrate toward the substrate surface with them rotating spirally, and the spiral pits deepen and enlarge when the number of spiral turns increases. When spiral pits are included in a portion (active region) in an electronic device or an optical device on which a nitride is stacked, the device performance remarkably deteriorates, to result in a device failure.

According to the current SiC wafer production technique, the density of micropipes which are giant hollow-core screw dislocations can be reduced to about $0/cm^2$, while screw dislocations are still included by about $10^4/cm^2$. This indicates that there are screw dislocations substantially at intervals of 100 μm. When spiral pits are formed, therefore, spiral pits resulting from screw dislocations are substantially reliably included in a device active region of 300 μm square, for example, and hence substantially all devices are defective, and the yield remarkably lowers. This is one of factors remarkably hindering industrial application of a gas-etched SiC wafer to nitride stacking.

Further, finishing of an SiC substrate by polishing requires long-term working, and hence the outer edge of the substrate is so excessively polished that the shape of the substrate disadvantageously deteriorates, and thickness variation of the substrate causes an inconvenience in production of a semiconductor device. An object of the present invention is to provide an SiC substrate excellent in flatness of the surface with a small number of spiral pits and a method for producing the same.

MEANS FOR SOLVING THE PROBLEMS

The present invention provides a method for producing a silicon carbide substrate for forming a semiconductor layer by inclining the surface orientation of a major surface of a substrate by 0.03° to 1° from the (0001) plane and performing hydrogen gas etching at 1250°C to 1700°C. It is preferable that the hydrogen gas etching comprises a step $\underline{A}$ of performing hydrogen gas etching at 1450°C to 1700°C and a step B of performing hydrogen gas etching at 1250°C to 1500°C. In this mode, proton irradiation, ion irradiation, electron beam irradiation or gamma ray irradiation is preferably performed after the first hydrogen gas etching step A and before the second hydrogen gas etching step B. A mode comprising the step B of performing hydrogen gas etching at 1250°C to 1500°C, the step A of performing hydrogen gas etching at 1450°C to 1700°C and the step B of performing hydrogen gas etching at 1250°C to 1500°C in this order is also preferable. In this mode, proton irradiation, ion irradiation, electron beam irradiation or gamma ray irradiation is preferably performed after the second hydrogen gas etching step A and before the third hydrogen gas etching step B.

The semiconductor layer can be formed on the major surface after all hydrogen gas etching steps, and the semiconductor layer formed on the major surface can be a layer consisting of silicon carbide, or a group II-VI semiconductor layer containing oxygen atoms, or a group III-V semiconductor layer containing nitrogen atoms. The semiconductor layer formed on the major surface is desirably formed under a temperature condition lower than the etching temperature in the hydrogen gas etching step carried out immediately before forming the semiconductor layer. Silicon carbide constituting the silicon carbide substrate preferably has a 6H-type crystal structure. Such a mode is preferable for the major surface that the surface orientation is inclined by 0.03° to 0.4° from the (0001) plane. Such a mode that the hydrogen gas etching is performed under an atmosphere having a hydrogen gas partial pressure of 267 Pa to 100 kPa is preferable, and it is more preferable if the substrate is held in an atmosphere having a temperature of 900°C to 1200°C and a hydrogen gas partial pressure of at least 13 kPa after the hydrogen gas etching steps. It is preferable that the aforementioned major surface has a step-terrace structure composed of flat terraces and steps (steps), and such a mode is preferable for this step-terrace structure of the major surface that the step between adjacent terraces has a length of integral times that of a c-axis unit lattice of silicon carbide. According to this method, a silicon carbide substrate having a diameter of at least 1.5 inches and surface flatness of not more than 5 $\mu$m can be produced. That subjected to proton irradiation, ion irradiation, electron beam irradiation or gamma ray irradiation can be preferably used as the substrate, and a mode of performing proton irradiation, ion irradiation, electron beam irradiation, gamma ray irradiation or silicon carbide homoepitaxial growth on the substrate subjected to the hydrogen gas etching is also preferable.

In a silicon carbide substrate according to the present invention, a major surface for forming a semiconductor layer has a step-terrace structure composed of flat terraces and steps, the surface orientation of the major surface is inclined by 0.03° to 1° from the (0001) plane, and the number of bowllike pit defects having a depth of at least 10 nm is not more than one in the range of 50 $\mu$m by 50 $\mu$m square on the major surface. Such a substrate that the steps terminate on a screw dislocation on the major surface and the number of spiral turns up to termination of the steps is not more than 5 is preferable. That having a 6H-type crystal structure can be preferably used as silicon carbide constituting the silicon carbide substrate. Such a mode is preferable for the major surface that the surface orientation is inclined by 0.03° to 0.4° from the (0001) plane, and such a mode is preferable for the step-terrace structure of the major surface that the step between adjacent terraces has a length of integral times that of a c-axis unit lattice of silicon carbide. Such an SiC substrate can be provided that the terrace width of the aforementioned step-terrace structure has a distribution and at least 90 % of the distribution of the terrace width in the range of 50 $\mu$m by 50 $\mu$m square is within ±10 % of the arithmetic mean of the terrace width in the same range. Further, a silicon carbide substrate having a diameter of at least 1.5 inches and surface flatness of not more than 5 $\mu$m can be provided.

EFFECTS OF THE INVENTION

Polishing for finish requiring a high cost can be omitted, and an SiC substrate having no shape deformation resulting from the polishing can be provided. Further, an SiC substrate having a small number of spiral pits can be provided, whereby flatness of the substrate surface for forming a nitride semiconductor layer can be improved.

BRIEF DESCRIPTION OF THE DRAWINGS

Fig. 1 is a diagram showing the surface orientation of a major surface of a substrate.
Fig. 2 is a conceptual diagram showing a section of a step-terrace structure on the surface of an SiC single-crystalline substrate.
Fig. 3 is a diagram enlarging one unit of the step-terrace structure shown in Fig. 2.
Fig. 4 is a diagram showing a state of spiral pits as viewed from above.
Fig. 5 is a diagram showing the relation between minimum radius of curvature (critical radius) and inclinations of a substrate.
Fig. 6 is a diagram showing the structure of a hydrogen etching furnace used in Example of the present invention.
Fig. 7 is a diagram showing the state of a major surface of 50 $\mu$m by 50 $\mu$m square in a case of employing a substrate having an inclination of 0.14°.

DESCRIPTION OF THE REFERENCE SIGNS

1 major surface, 21 terrace, 22 step, 51 substrate, 52 susceptor, 53 heat insulator, 54 coil, 55 quartz chamber, θ inclination.

BEST MODES FOR CARRYING OUT THE INVENTION

The present invention is now described in more detail. While the following embodiment is described with reference to the drawings, portions denoted by the same reference numerals in the drawings of the present invention indicate the same portions or corresponding portions.

(Silicon Carbide Substrate)

In the silicon carbide substrate according to the present invention, the major surface for forming the semiconductor layer preferably has a step-terrace structure, the surface orientation of the major surface is inclined by 0.03° to 1° from the (0001) plane, and the number of spiral pits which are bowllike pit defects having a depth of at least 10 nm is not more than one, preferably not more than 0.5 in the range of 50 $\mu$m by 50 $\mu$m square on the major surface. Therefore, the substrate surface for forming a nitride semiconductor layer or the like become flat, and the performance in an electronic device or an optical device can be improved. The shape of the pit defects or the like on the substrate surface can be measured with an Atomic Force Microscope (AFM). As to the number of defects (defect number), five portions in the range of 50 $\mu$m by 50 $\mu$m square are arbitrarily selected from the major surface and the respective defect numbers are measured, for regarding the average value thereof as the defect number. As to the spiral pits, steps grow from a screw dislocation of the SiC substrate toward the substrate surface with them rotating spirally, and the spiral pits deepen and enlarge when the number of spiral turns increases, to damage the flatness of the substrate. Therefore, such a mode is preferable for the major surface that the steps terminate on a screw dislocation and the number of spiral turns up to termination of the steps is not more than 5, and not more than one is more preferable. As to the number of spiral turns, five portions in the range of 50 $\mu$m by 50 $\mu$m square are arbitrarily selected from the major surface and the number of spiral turns every screw dislocation is measured as to each portion, for regarding the average value thereof as the number of spiral turns. As the SiC substrate, 6H-SiC in which pairs of silicon and carbon are stacked in a (0001) direction in six cycles or 4H-SiC in which the same are stacked in four cycles can be listed.

The major surface for forming the semiconductor layer preferably has the step-terrace structure, as shown in Fig. 2. Fig. 3 is an enlarged view of a portion 23 in Fig. 2. The relation between an inclination $\theta$, the step $\underline{h}$ and the length $\underline{w}$ of the terrace is as follows:

$$h = w \times \tan\theta$$

and hence the step $\underline{h}$ calculated by reading the lengths $\underline{w}$ of the terraces in cases where the inclinations $\theta$ are 0.1°, 0.3° and 0.5° respectively with the AFM is substantially 1.5 nm. This corresponds to a c-axis unit lattice length of 6H-SiC, and hence corresponds to six layers as regards the layer number of pairs of silicon and carbon. On the other hand, the cycle of stacking of a nitride semiconductor is two layers in pairs of a group III and nitrogen, and the aforementioned six layers correspond to three cycles of two layers. Therefore, the SiC substrate in the present invention is excellent in matching with heteroepitaxial growth of the nitride semiconductor in the case of the 6H type. Similarly, when the step between adjacent terraces has a length of integral times that of a c-axis unit lattice (six layers) of silicon carbide in the step-terrace structure of the major surface, this is advantageous since no stacking mismatch defect is caused.

(Method for Producing Silicon Carbide Substrate)

The present invention provides a method for producing a silicon carbide substrate whose major surface for forming a semiconductor layer has a step-terrace structure composed of flat terraces and steps (steps), by inclining the surface orientation of a major surface of a substrate by 0.03° to 1° from the (0001) plane and performing hydrogen gas etching at 1250°C to 1700°C. An SiC substrate preferable for stacking a nitride semiconductor can be provided by performing hydrogen etching under such a condition thereby increasing flatness of the substrate surface while suppressing growth of spiral pits.

The etching temperature is set to at least 1250°C, and preferably at least 1400°C in a point of increasing the etching rate. On the other hand, the etching temperature is set to not more than 1700°C, and preferably not more than 1500°C in a point of suppressing formation of spiral pits, suppressing growth even if the same are formed and obtaining a flat major surface. When performing etching at a constant temperature, therefore, a mode of performing the same at 1400°C to 1500°C is preferable, and formation of spiral pits can be effectively suppressed also by long-term etching.

A mode of adjusting the etching temperature in response to the state of flawing and roughening of the substrate surface before the etching is preferable. When the step B of performing hydrogen gas etching at 1250°C to 1500°C is executed after the step $\underline{A}$ of performing hydrogen gas etching at 1450°C to 1700°C, for example, the efficiency of the overall finishing steps can be increased and the cost can be reduced by removing deep flaws by the etching at the high temperature, performing efficient etching, and thereafter increasing the flatness of the substrate surface by the etching at the low temperature. When the inclination of the major surface of the substrate is sufficiently large, because it is hard to form spiral pits formation of spiral pits can be suppressed also by high-temperature etching. As to the relation between the process temperatures in the steps $\underline{A}$ and B, the process temperature in the step $\underline{A}$ may simply be higher than the process temperature in the step B.

If scratch by polishing or roughening of the substrate before etching is severe, it is possible to shallow the scratch by polishing by temporarily performing etching at a low temperature, thereafter increase the etching efficiency at a high temperature and finally improve the flatness of the substrate surface by etching at a low temperature when executing the method comprising the step B of performing hydrogen gas etching at 1250°C to 1500°C, the step A of performing hydrogen gas etching at 1450°C to 1700°C and the step B of performing hydrogen gas etching at 1250°C to 1500°C in this order, and such a phenomenon that spiral pits accidentally result from deep polishing flaws or roughening can be prevented while suppressing the inclination of the major surface small. This mode is advantageous also for reduction of the finishing time. As to the relation between the process temperatures in the steps A and B, the process temperature in the step A may simply be higher than the process temperatures in the steps B, similarly to the above. The process temperatures in the steps B before and after the step A may be identical to or different from each other.

Fig. 1 shows the surface orientation of the major surface of the substrate. As shown in Fig. 1, the inclination of a major surface 1 is the angle (inclination) $\theta$ between the normal of the substrate and the <0001> axis of a crystal, and the angle formed by major surface 1 of the substrate and the (0001) plane. The surface orientation of the major surface of the surface is inclined by a least 0.03° from the (0001) plane in a point of suppressing formation and growth of spiral pits, and the inclination is preferably at least 0.05°, and more preferably at least 0.1°. When a larger inclination is employed, it is preferable in a point of preventing formation of spiral pits resulting from accidental factors, while a large inclination causes a problem such as deterioration of crystallinity resulting from manifestation of c-axis lattice constant mismatching between SiC and the nitride semiconductor on step ends of the SiC substrate or such a problem that it is difficult to fabricate a device due to surface roughening (step bunching) on a nitride semiconductor growth surface resulting from the inclination in growth of a nitride semiconductor on the SiC substrate. From this point, the surface orientation of the major surface of the substrate is inclined by not more than 1° from the (0001) plane, and the inclination is preferably not more than 0.5°, and more preferably not more than 0.4°.

The inclination direction of the surface orientation of the major surface is expressed by an angle $\gamma$ between a straight line 2 formed by projecting the <0001> axis of the crystal on major surface 1 of the substrate and the <1-100> axis of the substrate, as shown in Fig. 1. Steps become three layers from six layers as the inclination direction of the crystal deviates from the <1-100> axis, i.e., as the value of $\gamma$ increases, and the $\gamma$ is preferably smaller since three layers are inferior in matching with the nitride semiconductor. While it is impossible to

completely eliminate the $\gamma$ value due to technical problems in production of the substrate, the $\gamma$ value is preferably not more than ±10°, more preferably not more than ±5°, and particularly preferably not more than ±2°.

The hydrogen gas etching can be performed in pure hydrogen gas or a mixed gas atmosphere of hydrogen gas and arbitrary gas. In a point of preventing formation of a carbide layer on the SiC substrate surface resulting from excess desorption of Si, a hydrogen gas partial pressure is preferably at least 267 Pa, and more preferably at least 500 Pa. On the other hand, In points of preventing formation of Si particles on the SiC substrate surface caused by excess removal of C resulting from an excess hydrogen partial pressure, properly reducing the hydrogen partial pressure, suppressing the rate of gas etching, performing stable step formation and suppressing formation of spiral pits, the hydrogen gas partial pressure for the hydrogen gas etching is preferably not more than 100 kPa, and more preferably not more than 13 kPa. Further, a mode of executing hydrogen gas etching at 1250°C to 1700°C with a hydrogen gas partial pressure of not more than 13 kPa, for example, and thereafter holding the substrate in an atmosphere of 900°C to 1200°C with a hydrogen gas partial pressure of at least 13 kPa is preferable. According to this mode, Si is etched in the first high-temperature low-pressure atmosphere, and both of Si and C can be held in the substrate in the subsequent low-temperature high-pressure atmosphere.

While the surface of the SiC substrate is flattened to about 0.1 nm in arithmetic mean roughness (Ra) by chemical polish finishing, SiC is so hard and chemically stable as to require a long process time and a high cost. Further, the substrate outer peripheral edge is more excessively polished than the central portion by long-term polishing, and hence the substrate shape is so deteriorated that surface flatness of a substrate having a diameter of 1.5 inches, for example, increases to 8 $\mu$m after the polishing, although the same has been 3 $\mu$m before chemical polishing. According to the inventive production method, an SiC substrate having a diameter of at least 1.5 inches and surface flatness of preferably not more than 5 $\mu$m, more preferably not more than 2 $\mu$m, can be produced by prescribed hydrogen etching, without performing chemical polishing. The surface flatness is measured with a surface measuring apparatus optically measuring the shape of the surface with interference of a laser beam.

An impurity concentration can be controlled by performing ion implantation on the SiC substrate in the production steps. For example, the impurity concentration can be controlled by using a substrate subjected to ion implantation. When comprising the step A of performing hydrogen gas etching at 1450°C to 1700°C and the step B of performing hydrogen gas etching at 1250°C to 1500°C, a mode of performing ion implantation after the first hydrogen gas etching step A and before the second hydrogen gas etching step B is advantageous in a point of preventing diffusion of a dopant in a case where the dopant easily diffuses due to the high temperature in the first hydrogen etching and the dopant hardly diffuses due to the low temperature in the second hydrogen etching. When performing ion implantation after the second hydrogen etching step B and thereafter forming the semiconductor layer on the major surface at a temperature of not more than the second hydrogen gas etching temperature, this is preferable in a point that diffusion of the dopant resulting from heating in the hydrogen gas etching can be prevented. Further, this is preferable also in a point that diffusion and recombination of point defects formed by ion implantation or formation of complex defects can be avoided. Thus, a mode of forming the semiconductor layer on the major surface after all hydrogen gas etching steps and forming the semiconductor layer formed on the major surface at a temperature lower than the etching temperature in the hydrogen gas etching step carried out immediately before the formation of the semiconductor layer is preferable. In addition, ion implantation is performed after the second hydrogen gas etching step B, and the semiconductor layer can be thereafter formed on the major surface at a temperature of at least the second hydrogen gas etching temperature.

The mode of executing ion implantation after the first hydrogen gas etching step A and before the second hydrogen gas etching step B is advantageous in the case of the dopant easily diffusing due to the high temperature in the first hydrogen etching and hardly diffusing at the low temperature in the second hydrogen etching. In this case, it is preferable also in a point that an impurity or a small flaw adhering to or formed on the substrate surface in the ion implantation step can be removed by the second hydrogen gas etching. A similar mode can be applied to a case of controlling various characteristics of SiC by proton irradiation, ion irradiation, electron beam irradiation or gamma ray irradiation, in place of the ion implantation. In other words, the order of the first and second hydrogen gas etching steps and the aforementioned process can be selected in response to largeness/smallness of a heat process temperature necessary after the process for controlling various characteristics of SiC or a temperature exerting bad influence on control of target characteristics and the gas etching temperature. After all hydrogen gas etching steps, a layer consisting of silicon carbide, or a group II-VI semiconductor layer containing oxygen atoms, or a group III-V semiconductor layer containing nitrogen atoms can be formed on the major surface. An arbitrary formation process such as vapor phase epitaxy, molecular beam epitaxy, pulse laser ablation or sputtering can be employed for formation of the semiconductor layer.

When the hydrogen gas etching steps include the first step B of performing hydrogen gas etching at 1250°C to 1500°C, the second step A of performing hydrogen gas etching at 1450°C to 1700°C and the third step B of performing hydrogen gas etching at 1250°C to 1500°C, a mode of performing ion implantation after the second hydrogen gas etching step A and before the third hydrogen gas etching step B is advantageous in the point of preventing diffusion of the dopant in a case where the dopant easily diffuses due to the high temperature in the second hydrogen etching and the dopant hardly diffuses due to the low temperature in the third hydrogen etching. When performing ion implantation, proton irradiation, electron beam irradiation, gamma ray irradiation or silicon carbide homoepitaxial growth on the substrate subjected to hydrogen gas etching, this is preferable in a point that various characteristics such as conductivity of the overall SiC substrate or in the vicinity of the SiC substrate surface can be arbitrarily controlled. When homoepitaxial growth is performed, further, this is preferable in a point that crystallinity of SiC in the vicinity of the surface can be remarkably improved.

A conventional SiC substrate was not homogeneous in crystallinity and the surface orientation of a major surface remarkably deviated in a single substrate, and hence it was not possible to homogenize the directions and shapes of steps unless providing a inclination of about 0.5°. However, it has been rendered possible to control the inclination and the inclination direction of the surface orientation of the substrate in a small range of not more than 0.2° due to improvement in the quality of the SiC substrate, and it has been rendered possible to homogenize the directions and shapes of steps in a single substrate with a small inclination. In the present invention, at least 90 % of distribution of terrace widths in the range of 50 $\mu$m by 50 $\mu$m square, for example, can be adjusted within $\pm$10 % of the arithmetic mean of the terrace widths in the range of 50 $\mu$m by 50 $\mu$m square in the step-terrace structure of the major surface.

While the present invention is now described in more detail with reference to Examples, the present invention is not restricted to these.

<Examples>

Example 1

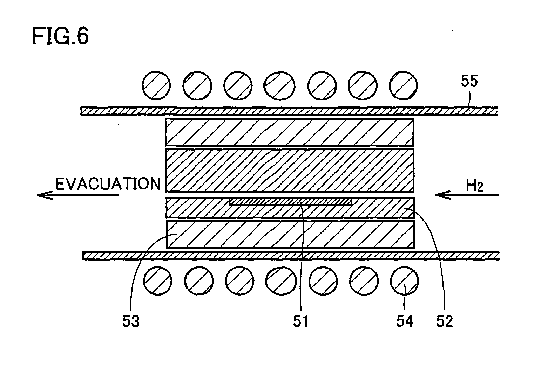

As shown in Fig. 6, a 2-inch substrate 51 of 6H-SiC whose (0001) plane was polished into a mirror surface was set in a susceptor 52 of a hydrogen etching furnace. As to the surface orientation of the major surface in the SiC substrate, an inclination was set to 0.03° to 0.5° from the (0001) plane toward the (1-100) plane. Susceptor 52 in the furnace is made of high-purity graphite coated with SiC, and a heat insulator 53 is made of fibrous graphite. A coil 54 was arranged on the outer periphery of the furnace through a quartz chamber 55, and a high-frequency current was fed to the coil for induction-heating the SiC substrate in the furnace. The temperature on the lower side of the susceptor was measured with a radiation thermometer, the induction current was controlled, and the temperature was set to 1450°C. High-purity hydrogen of 6N was fed into the furnace at 0.1 cm$^3$/min., and the furnace was evacuated and replaced with a hydrogen atmosphere of 3 kPa for performing etching. After the furnace was held at the etching temperature for at least 30 minutes, the temperature was reduced. The pressure in the temperature reduction was set to 900 kPa. This is because it has been confirmed that droplets of Si remain on the substrate surface if the atmosphere is kept at 3 kPa.

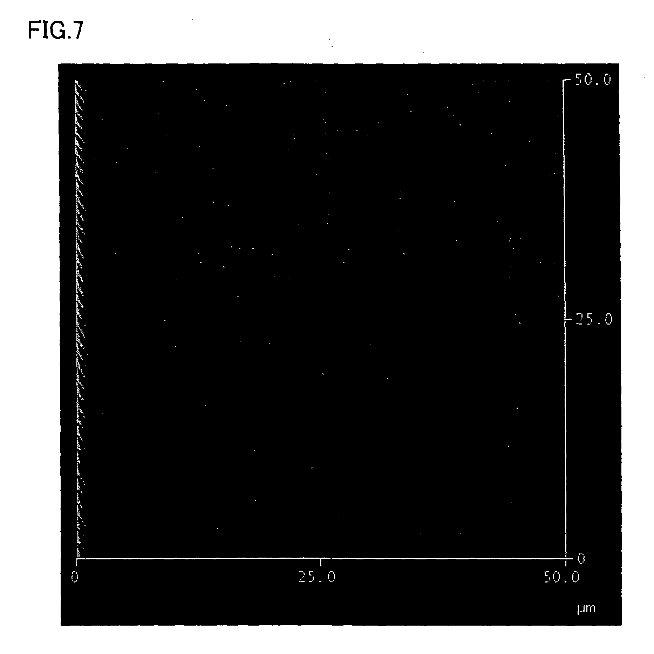

When the major surface of the substrate was observed with an AFM after the hydrogen etching, a step-terrace structure had been formed. Fig. 7 illustrates the state (AFM photograph) of a major surface of 50 $\mu$m by 50 $\mu$m square in a case of employing a substrate having an inclination of 0.14°. As shown in Fig. 7, no bowllike pit defects having a depth of at least 10 nm were present in the range of 50 $\mu$m by 50 $\mu$m square. Further, the average (average on six portions in total) with measurement on other arbitrary five portions was 0.17. In addition, steps terminated on screw dislocation of the major surface, and the average of the numbers of spiral turns up to termination of the steps was 0.8 times.

Example 2

An SiC substrate was produced similarly to Example 1 with respect to a substrate having a major surface whose surface orientation was inclined by 0.02° from the (0001) plane toward the (1-100) plane. As a result, bowllike pit defects (spiral pits) as shown in Fig. 4 were observed by an AFM. The minimum radius of curvature (critical radius; corresponding to 1/4 of the distance between two arrows shown in Fig. 4) of a step present on the innermost periphery of the central portion of the pits shown in Fig. 4 was 725 nm. When the width of steps originally present in the substrate was larger than the minimum radius of curvature of the spiral pits, the steps from the screw dislocations hardly coupled with the steps resulting from the substrate inclination due to the inclination from the (0001) plane of the substrate, bowllike etching progressed, and the spiral pits were formed. When the step width was smaller than the minimum radius of curvature, on the other hand, no spiral pits were formed.

As shown in Fig. 3, the relation between the inclination θ, the step h and the length w of the terraces is as follows:

$$h = w \times \tan\theta$$

and the step h was 1.5 nm in the case of 6H-SiC, substitution of w = 725 nm resulted in θ = 0.12°, and no spiral pits were formed when θ ≥ 0.12°. Similarly, the minimum radius of curvature was 480 nm when performing hydrogen etching at 1650°C, and hence substitution of step h = 1.5 nm and w = 480 nm resulted in θ = 0.18°, and no spiral pits were formed when θ ≥ 0.18°.

On the basis of these results, minimum radii of curvature (critical radius) (black circles) and inclinations (white circles) of the substrate were plotted in Fig. 5. Further, a graph of an inclination necessary for suppressing spiral pits was shown. As shown in Fig. 5, 1000/T (K) = 1000/(1250 + 273) = 0.66 when the etching temperature is 1250°C, and hence formation of spiral pits can be suppressed when the inclination θ ≥ 0.03° from Fig. 5. Similarly, 1000/T (K) = 1000/(1700 + 273) = 0.51 when the etching temperature is 1700°C, and hence formation of spiral pits can be suppressed when the inclination θ ≥ 0.3° from Fig. 5. In practice, it is preferable to largely set the inclination θ in consideration of fluctuation resulting from dispersion of the surface orientation in the planes of the SiC substrate.

The minimum radius of curvature depends on the specification of the etching furnace, the etching gas atmosphere and the hydrogen partial pressure. In production, a hardly inclined SiC substrate may be employed for performing test etching at a plurality of temperatures, actually measuring critical radius of intentionally formed spiral pits, creating a diagram such as that shown in Fig. 5 correspondingly to respective apparatuses and etching conditions, and deciding the inclination of the substrate on the basis of the diagram.

While the embodiment and Examples of the present invention have been described, proper combinations of the structures of the aforementioned embodiment and Examples are also planned from the outset.

The embodiment and Examples disclosed this time are to be considered as illustrative in all points, and not restrictive. The range of the present invention is shown not by the above description but by the scope of claims for patent, and it is intended that all modifications within the meaning and range equivalent to the scope of claims for patent are included.

INDUSTRIAL APPLICABILITY

Flatness of a substrate surface for stacking a nitride semiconductor layer or the like is so high that device performance in an electronic device or an optical device can be improved.

**Claims**

1. A method for producing a silicon carbide substrate whose major surface for forming a semiconductor layer has a step-terrace structure composed of flat terraces and steps, by inclining the surface orientation of a major surface (1) of a substrate by 0.03° to 1° from the (0001) plane and performing hydrogen gas etching at 1250°C to 1700°C.

2. The method for producing a silicon carbide substrate according to claim 1, wherein said hydrogen gas etching comprises a step A of performing hydrogen gas etching at 1450°C to 1700°C and a step B of performing hydrogen gas etching at 1250°C to 1500°C in this order.

3. The method for producing a silicon carbide substrate according to claim 2, performing proton irradiation, ion irradiation, electron beam irradiation or gamma ray irradiation after said step A and before said step B.

4. The method for producing a silicon carbide substrate according to claim 1, wherein
said hydrogen gas etching comprises a step B of performing hydrogen gas etching at 1250°C to 1500°C, a step A of performing hydrogen gas etching at 1450°C to 1700°C and the step B performing hydrogen gas etching at 1250°C to 1500°C in this order.

5. The method for producing a silicon carbide substrate according to claim 4, performing proton irradiation, ion irradiation, electron beam irradiation or gamma ray irradiation after said step A and before said step B.

6. The method for producing a silicon carbide substrate according to claim 1, comprising the step of forming a semiconductor layer on the major surface (1) after all hydrogen gas etching steps.

7. The method for producing a silicon carbide substrate according to claim 6, wherein
said semiconductor layer formed on the major surface is a layer consisting of silicon carbide, or a group II-VI semiconductor layer containing oxygen atoms, or a group III-V semiconductor layer containing nitrogen atoms.

8. The method for producing a silicon carbide substrate according to claim 6, forming said semiconductor layer formed on the major surface under a temperature condition lower than the etching temperature in the hydrogen gas etching step carried out immediately before forming the semiconductor layer.

9. The method for producing a silicon carbide substrate according to claim 1, wherein
silicon carbide constituting said silicon carbide substrate is 6H-silicon carbide.

10. The method for producing a silicon carbide substrate according to claim 1, inclining the surface orientation of said major surface (1) by 0.03° to 0.4° from the (0001) plane.

11. The method for producing a silicon carbide substrate according to claim 1, performing said hydrogen gas etching under an atmosphere having a hydrogen gas partial pressure of 267 Pa to 100 kPa.

12. The method for producing a silicon carbide substrate according to claim 11, comprising the step of holding said substrate in an atmosphere having a temperature of 900°C to 1200°C and a hydrogen gas partial pressure of at least 13 kPa after said hydrogen gas etching step.

13. The method for producing a silicon carbide substrate according to claim 1, wherein
the step between adjacent terraces has a length of integral times that of a c-axis unit lattice of silicon carbide in said step-terrace structure.

14. The method for producing a silicon carbide substrate according to claim 1, producing a silicon carbide substrate having a diameter of at least 1.5 inches and surface flatness of not more than 5 $\mu$m.

15. The method for producing a silicon carbide substrate according to claim 1, wherein
said substrate is subjected to proton irradiation, ion irradiation, electron beam irradiation or gamma ray irradiation.

16. The method for producing a silicon carbide substrate according to claim 1, performing proton irradiation, ion irradiation, electron beam irradiation, gamma ray irradiation or silicon carbide homoepitaxial growth on said substrate subjected to said hydrogen gas etching.

17. A silicon carbide substrate in which the surface orientation of a major surface (1) for forming a semiconductor layer is inclined by 0.03 to 1° from the (0001) plane and the number of bowllike pit defects having a depth of at least 10 nm is not more than one in the range of 50 $\mu$m by 50 $\mu$m square on the major surface (1).

18. The silicon carbide substrate according to claim 17, wherein
the major surface (1) for forming said semiconductor layer has a step-terrace structure composed of flat terraces (21) and steps (22), the steps (22) terminate on a screw dislocation on said major surface (1), and the number of spiral turns up to termination of the steps (22) is not more than 5.

19. The silicon carbide substrate according to claim 17, wherein silicon carbide constituting said silicon carbide substrate is 6H-silicon carbide.

20. The silicon carbide substrate according to claim 17, wherein
said major surface (1) is such a major surface that the surface orientation is inclined by 0.03 to 0.4° from the (0001) plane.

**21.** The silicon carbide substrate according to claim 17, wherein

the major surface (1) for forming said semiconductor layer has a step-terrace structure composed of flat terraces (21) and steps (22), and the step (22) between adjacent terraces (21) has a length of integral times that of a c-axis unit lattice of silicon carbide in said step-terrace structure.

**22.** The silicon carbide substrate according to claim 17, wherein

the major surface (1) for forming said semiconductor layer has a step-terrace structure composed of flat terraces (21) and steps (22), the terrace width of said step-terrace structure has a distribution, and at least 90 % of the distribution of the terrace width in the range of 50 $\mu$m by 50 $\mu$m square is within $\pm$10 % of the arithmetic mean of the terrace width in said range of 50 $\mu$m by 50 $\mu$m square.

**23.** The silicon carbide substrate according to claim 17, wherein

said silicon carbide substrate has a diameter of at least 1.5 inches and surface flatness of not more than 5 $\mu$m.

FIG.1

(NORMAL OF SUBSTRATE)

$\theta$

<0001>AXIS

1

$\gamma$

<11-20>AXIS

<1-100>AXIS

2

FIG.2

23

21    22

FIG.3

w

h

$\theta$

FIG.4

FIG.5

## FIG.6

FIG.7

## INTERNATIONAL SEARCH REPORT

| | International application No. |
|---|---|
| | PCT/JP2007/066343 |

A.  CLASSIFICATION OF SUBJECT MATTER
*H01L21/302*(2006.01)i, *H01L21/205*(2006.01)i, *H01L33/00*(2006.01)i

According to International Patent Classification (IPC) or to both national classification and IPC

B.  FIELDS SEARCHED

Minimum documentation searched (classification system followed by classification symbols)
H01L21/302, H01L21/205, H01L33/00

Documentation searched other than minimum documentation to the extent that such documents are included in the fields searched
Jitsuyo Shinan Koho          1922-1996    Jitsuyo Shinan Toroku Koho    1996-2007
Kokai Jitsuyo Shinan Koho    1971-2007    Toroku Jitsuyo Shinan Koho    1994-2007

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br>Y<br>A | WO 2005/093796 A1  (The Kansai Electric Power Co., Inc.),<br>06 October, 2005 (06.10.05),<br>Par. Nos. [0019] to [0049]<br>& EP 1739726 A1          & JP 2005-311348 A | 1,6-9,11,12,<br>14,16<br>10,13,17-23<br>2-5,15 |
| Y | JP 11-233391 A  (Nippon Telegraph And Telephone Corp.),<br>27 August, 1999 (27.08.99),<br>Par. Nos. [0005] to [0007]<br>(Family: none) | 10,13,17-23 |
| Y | WO 2005/034208 A2  (CREE INC.),<br>14 April, 2005 (14.04.05),<br>Page 2, line 15 to page 14, line 25<br>& US 2005/0064723 A1     & EP 1665343 A1 | 18,22 |

☐  Further documents are listed in the continuation of Box C.          ☐  See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>01 November, 2007 (01.11.07) | Date of mailing of the international search report<br>20 November, 2007 (20.11.07) |
|---|---|
| Name and mailing address of the ISA/<br>Japanese Patent Office | Authorized officer |
| Facsimile No. | Telephone No. |

Form PCT/ISA/210 (second sheet) (April 2007)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001077030 A